# FASCICULE DE BREVET EUROPEEN

(11) **EP 0 536 034 B1**
(45) Date de publication et mention de la délivrance du brevet: **04.09.1996**
(21) Numéro de dépôt: 92402652.9
(22) Date de dépôt: 28.09.1992
(51) Int. Cl.: C04B 35/00, C04B 35/64

(54) **Procédé de contrôle pour l'élaboration d'un matériau supraconducteur à haute température critique**
Verfahren zur Herstellung eines Hochtemperatur supraleitenden Stoffs
Method for the elaboration of a high critical temperature superconducting material

(30) Priorité: 30.09.1991 FR 9111990
(43) Date de publication de la demande: 07.04.1993
(73) Titulaire: ALCATEL ALSTHOM COMPAGNIE GENERALE D'ELECTRICITE, F-75382 Paris Cédex 08 (FR)
(72) Inventeur: Duperray, Gérard, F-91290 La Norville (FR)
(74) Mandataire: Laroche, Danièle

(56) Documents cités:
- CHEMICAL ABSTRACTS, vol. 112, no. 14, 2 Avril 1990, Columbus, Ohio, US; abstract no. 130159a, V. BOFFA ET AL. 'EFFECTS OF SINTERING CONDITIONS ON THE TRANSPORT PROPERTIES OF YTTRIUM BARIUM COPPER OXIDE PELLETS'
- JOURNAL OF MATERIALS SCIENCE, vol. 25, no. 11, Novembre 1990, London GB pages 4852 - 4855 D. BAHADUR ET AL. 'EFFECT OF OPTIMUM THERMAL TREATMENT ON BiSrCaCu20y' EXPERIMENTAL PROCEDURE;
- JAPANESE JOURNAL OF APPLIED PHYSICS, vol. 28, no. 5, Mai 1989, Tokyo JP pages 772 - 774 S. KOBAYASHI ET AL. 'THE EFFECT OF SINTERING CONDITIONS ON THE FORMATION OF THE HIGH-Tc PHASE IN THE Bi-Sr-Ca-Cu-O SYSTEM'
- JOURNAL OF VACUUM SCIENCE & TECHNOLOGY A, vol. 9, no. 3, Juin 1991, US pages 394 - 400 L.M. CHEN ET AL. 'STUDIES OF THE BEHAVIOUR OF THE '123' SUPERCONDUCTOR SYSTEM DURING CHANGES IN ATMOSPHERIC CONDITIONS'

## Description

La présente invention concerne un procédé de contrôle pour l'élaboration d'un matériau supraconducteur à haute température critique.

On sait que les matériaux supraconducteurs à haute température critique dont la composition répond aux formules :

(BP)₂Sr₂CaₙCu₍₁₊ₙ₎O₍₆₊₂ₙ₎

avec
- BP =: Bi ; Bi₍₁₋ₓ₎Pbₓ
- n =: 0 ; 1 ; 2
ont la particularité de présenter des domaines de stabilité thermodynamique étroits. Aussi, lors de la synthèse, si les paramètres ne sont pas dans les bonnes fourchettes, on obtient des mélanges dans lesquels la phase supraconductrice intéressante visée est noyée dans d'autres phases supraconductrices inintéressantes à basse température critique et dans d'autres composés parasites.

L'article paru dans "Physica C162-164 (1984) 913-914 "Effects of sintering conditions on the Transport Properties of YBaCuO Pellets" par V. Boffa et al," montre par exemple l'influence de la température de frittage sur la résistivité d'un échantillon de YBaCuO.

Outre les paramètres thermodynamiques (pression d'oxygène, stoechiométrie et température), d'autres paramètres interviennent de façon cinétique sur la synthèse : homogénéité, état de division, compactage et pureté des réactifs précurseurs, répartition du flux gazeux, profil thermique en fonction du temps, présence de gradients involontaires dans le four de traitement et temps de réaction.

Pour tenir compte de cet état de fait, les opérateurs qui effectuent ces synthèses procèdent de la manière suivante :
En contrôlant rigoureusement les paramètres, ils mènent d'abord une optimisation préalable avec le matériel utilisé, en faisant varier un à un les paramètres ; puis, fixant autant que posible ces derniers aux valeurs ainsi déterminées, ils effectuent la synthèse de manière plus ou moins reproductible.
Cette méthode présente plusieurs inconvénients :
- Elle est longue et fastidieuse.
- Tout est remis en question quand un paramètre varie par suite de dérives involontaires : vieillissement du matériel, évolution des matières premières, changement d'opérateur, etc.
- Il faut attendre la fin des opérations pour savoir si le produit est correct ou non.

La présente invention a pour but de rechercher un moyen de contrôle permettant à l'opérateur de suivre en temps réel la bonne marche de la synthèse, et en particulier d'être averti de tout début d'anomalie ; il doit pouvoir ainsi la corriger immédiatement en modifiant un paramètre, tel que la température, la pression partielle d'oxygène ou le temps de réaction.

La présente invention a pour objet un procédé de contrôle pour l'élaboration d'un matériau supraconducteur à haute température critique de formule :

(BP)₂Sr₂CaₙCu₍₁₊ₙ₎O₍₆₊₂ₙ₎

avec
- BP =: Bi₍₁₋ₓ₎Pbₓ
- n =: 0 ; 1 ; 2,
procédé selon lequel :
- on part d'un mélange de poudres des précurseurs dudit matériau avec la stoechiométrie de la phase supraconductrice souhaitée,
- on agglomère ledit mélange pour former une pièce tubulaire ou cylindrique,
- on place la pièce agglomérée dans un four à atmosphère contrôlée pour réaliser la synthèse de ladite phase supraconductrice,
- on mesure de manière continue la conductivité de ladite pièce,
   caractérisé par le fait que :
- on dépasse la température pour laquelle la conductivité amorce une décroissance puis on revient à une valeur où la conductivité recommence à croître,
- on règle en permanence la température du four de manière à ce que ladite conductivité ne décroisse pas et se trouve à la limite d'un coude de décroissance.

Au cours de la montée initiale de la température, lorsque la phase supraconductrice commence à se former, la conductivité commence a apparaître et croît avec la température ; dès que survient une décroissance brutale de la conductivité, il faut stopper la croissance de la température car on est parvenu au début de la fusion partielle de ladite pièce, correspondant aux conditions idéales pour poursuivre la synthèse. La réaction continue alors, et la conductivité recommence a croître en fonction du temps. Il est alors possible de refaire croître la température jusqu'à l'amorçage d'un nouveau coude de décroissance de la conductivité.
Ainsi, au cours de l'avancement de la réaction, ou par suite d'une variation involontaire de la pression partielle d'oxygène, on corrige la température pour se trouver à la limite d'un coude de décroissance de conductivité.

Bien que la conductivité croisse normalement au fur et à mesure que la concentration de la phase synthétisée augmente, on constate que le coude susceptible d'apparaître est de plus en plus prononcé, autrement dit que la fourchette de température pour obtenir une phase parfaite est de plus en plus étroite.

De préférence les précurseurs utilisés sont choisis parmi :
SrCO₃
CaCO₃ ou CaO
Bi₂(CO₃)₃ ou Bi₂O₃
PbCO₃ ou PbO ou Pb₃O₄ .

Le procédé selon l'invention est particulièrement avantageux pour la réalisation de la phase supraconductrice Bi₂Sr₂Ca₂Cu₃O₁₀, habituellement dégradée de manière irréversible par la formation de (CaSr)₂CuO₃ et Bi₂Sr₂CuO₆, dégradation accompagnée par un effondrement de la conductivité.

La conductivité est de préférence mesurée par la méthode dite méthode des "quatre points" impliquant quatre contacts. Ainsi on impose un courant entre les deux contacts extrêmes et on mesure la chute ohmique dans ladite pièce entre deux autres contacts situés sur le passage dudit courant.

Lesdits contacts sont réalisés en des métaux ne réagissant pas avec les réactifs en présence ou les produits de la synthèse : on choisit de préférence l'argent, le platine, le rhodium ou l'or : ils se présentent sous forme de laque déposée sur la surface de ladite pièce, ou de fils noyés dans ladite pièce, ou de colliers, ou de ressorts agissant par pression sur cette pièce.

D'autres caractéristiques et avantages de la présente invention apparaîtront au cours de la description suivante de modes de réalisation donnés à titre illustratif mais nullement limitatif. Dans le dessin annexé :
- La figure 1 est une courbe montrant l'évolution de la résistivité en fonction de la température d'un matériau traité selon le procédé de l'invention,
- La figure 2 montre un spectre de diffraction X correspondant au matériau associé à la figure 1,
- La figure 3 est une courbe montrant l'évolution de la résistivité du matériau des figures 1 et 2 en fonction de la température T (K),
- La figure 4 est analogue à la figure 2 et correspond à un matériau non contrôlé conformément au procédé selon l'invention,
- La figure 5 montre l'évolution de la résistivité en fonction de la température d'un autre matériau traité selon le procédé de l'invention.

### Exemple I

On comprime isostatiquement sous forme d'un barreau de diamètre 5 mm et de longueur 50 mm, un mélange préalablement broyé de Bi₂O₃, PbCO₃, SrCO₃, CaCO₃ et CuO dans les proportions correspondant à la stoechiométrie :

Bi_{1,6}Pb_{0,4}Sr₂Ca₂Cu₃O₁₀

On dispose sur ce barreau quatre contacts en forme de colliers en fil d'argent. L'ensemble est placé dans un four sur un support réfractaire muni de quatre conducteurs en platine permettant de relier les contacts du barreau à un générateur de courant et à un millivoltmètre.
Les débits d'azote et d'oxygène sont réglés pour obtenir un balayage de 50 litres par heure à 10 % d'oxygène.
La température est élevée jusqu'à 800°C à raison de 120°C par heure, puis jusqu'à 840°C à raison de 30°C par heure.

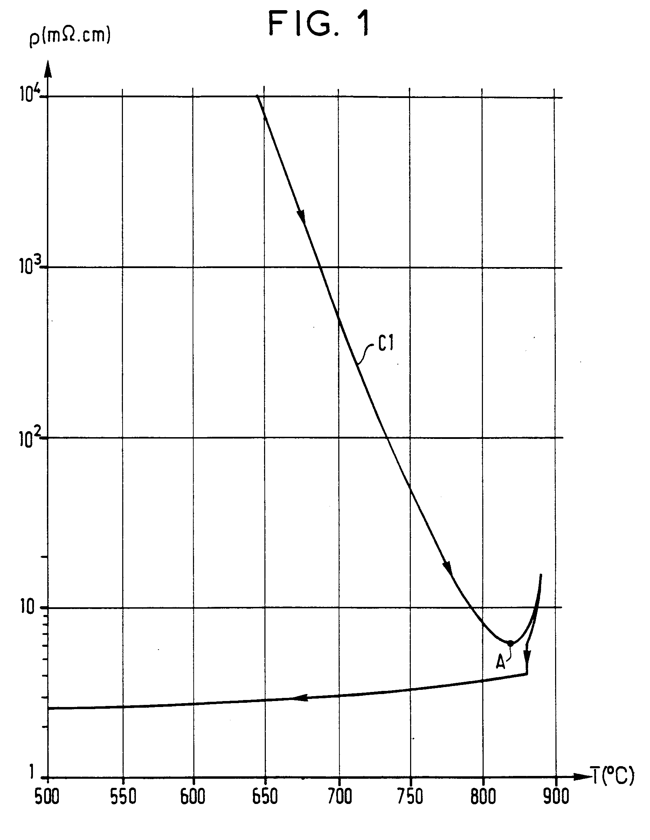

La figure 1 montre l'évolution (C₁) de la résistivité ρ (mΩ.cm) en fonction de la température T(°C).

On observe que la résistivité décroît régulièrement jusqu'au point A et qu'elle amorce un coude vers 820°C. On redescend alors la température à 830°C et on effectue un palier de 67 heures à 830°C. La résistivité continue à décroître. On refroidit alors jusqu'à la température ambiante à raison de 120°C par heure sous oxygène pur.

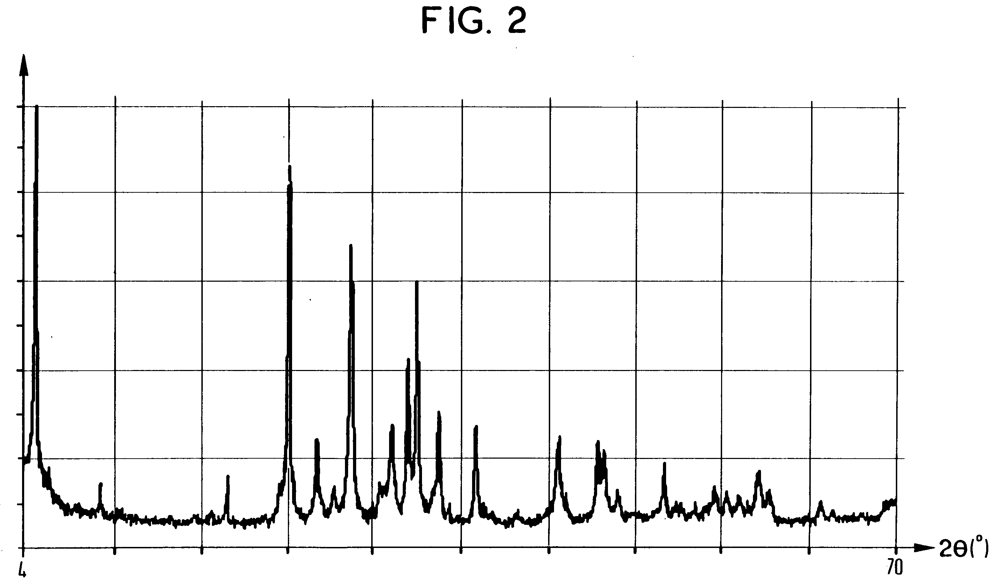

Le matériau obtenu est analysé par diffraction X. Le spectre apparaît dans la figure 2 avec l'angle de diffraction 2 θ en abscisses. On constate que le matériau contient environ 85 % de la phase Bi₂Sr₂Ca₂Cu₃O₁₀.

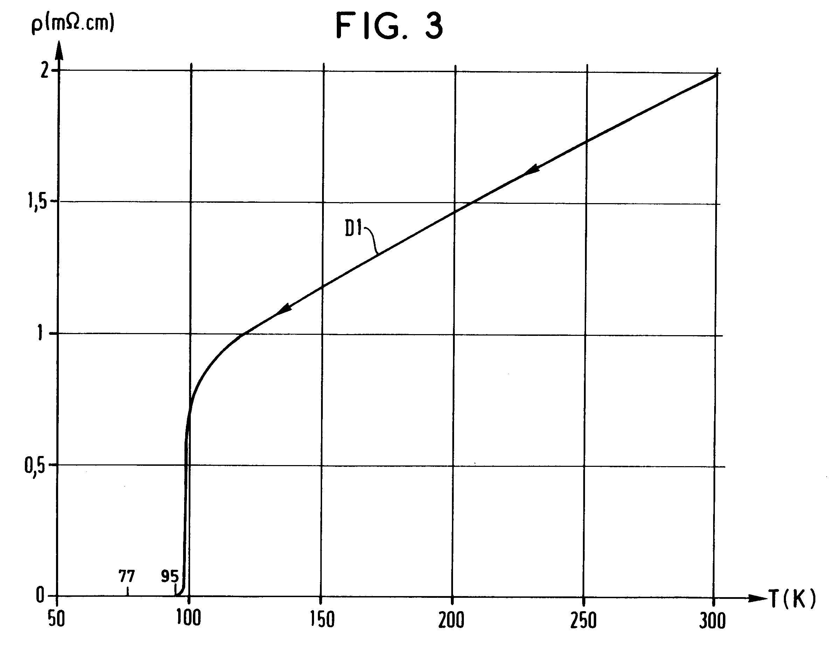

On mesure la résistivité ρ (mΩ.cm) du matériau en fonction de la température T (K). On obtient la courbe D₁ de la figure 3. Il apparaît que la transition s'effectue vers 100 K, la résistance nulle étant effective à 95K.

### Exemple II

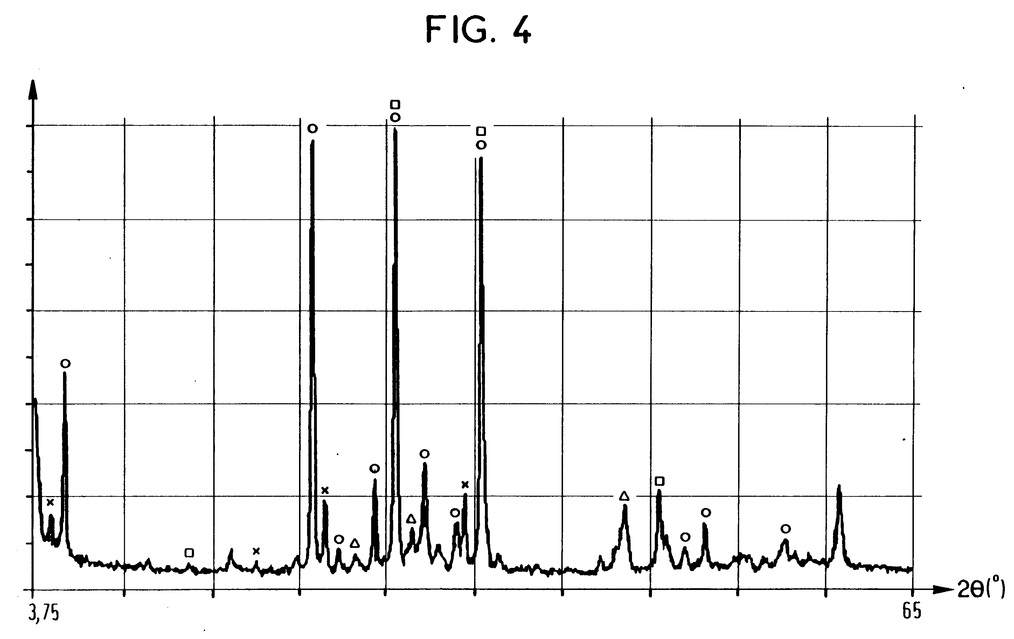

Il est identique au précédent, sauf en ce qui concerne la température de traitement que l'on maintient à 840°C pendant 2 heures : la résistivité, au lieu de décroître, passe de 15 mΩ.cm à 280 mΩ.cm. Après refroidissement, le barreau présente l'aspect fondu avec, en surface, des cristaux aciculaires de couleur dorée ; il adhère au support. Ce barreau, retraité à 830°C pendant 120 heures sous 10 % d'oxygène, ne voit pas sa résistivité baisser notablement. La composition finale révélée par diffraction X (cf spectre de la figure 4) indique une proportion minime de phase dans un mélange de :
Bi₂Sr₂Ca₂Cu₃O₁₀ (x)
Bi₂Sr₂CaCu₂O₈ (o)
Bi₂Sr₂CuO₆ (△)
Ca₂CuO₃ (□).

Cet exemple illustre le caractère irréversible de la décomposition par fusion : le seul moyen pour reprendre la synthèse de la phase à 100 K consiste à broyer l'échantillon fondu, le remettre en forme et le retraiter dans les conditions de l'exemple I, c'est-à-dire revenir au point de départ.

### Exemple III

Il est identique à l'exemple I, sauf en ce qui concerne l'atmosphère de traitement qui ne contient plus que 5 % d'oxygène, ce qui a pour effet d'abaisser le point de fusion des phases fusibles riches en cuivre. Le coude de résistivité se situe dans ce cas vers 810°C. En conséquence, après une brève excursion vers 830°C, on effectue la synthèse à 820°C pendant 75 heures. Le produit obtenu est constitué de Bi₂Sr₂Ca₂Cu₃O₁₀ à plus de 85 % sous forme de cristaux de taille importante : 15 à 20 µm.

### Exemple IV

Il est identique à l'exemple I, sauf en ce qui concerne la composition de départ : aux précurseurs indiqués on ajoute 10 % en poids de poudre d'argent. Comme pour l'exemple III, la température de traitement se trouve abaissée de 10°C environ. Le produit obtenu est aussi riche en phase à 110 K, mais les cristaux ont une taille plus faible, inférieure à 10 µm.

### Exemple V

Le produit synthétisé lors de l'exemple I est écrasé entre les rouleaux d'un laminoir, en plusieurs passes, jusqu'à une épaisseur de 0,5 mm. On découpe dans le matériau ainsi laminé une barrette de 30 x 5 x 0,5 mm.

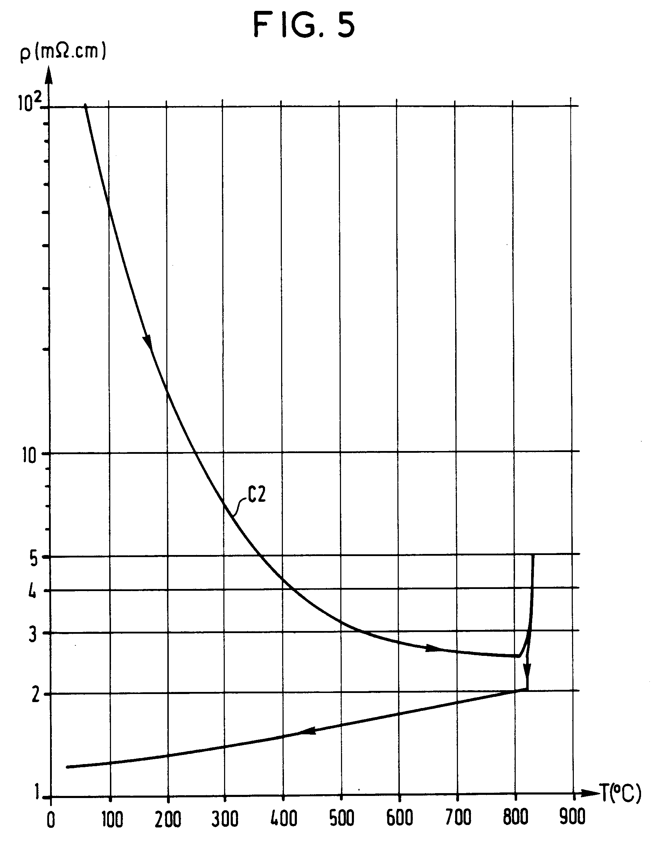

On retraite cette barrette par le procédé selon l'invention. La figure 5 montre la courbe C₂ d'évolution de la résistivité en fonction de la température.
La résistivité ρ , qui était passée de 2 mΩ.cm à 500 mΩ.cm après laminage et mise en forme, décroît rapidement en fonction de la température et amorce un coude à 810°C. Après une brève excursion à 835°C, on ramène la température à 820°C et on la maintient 40 heures à cette valeur. Le retour à l'ambiante est effectué à raison de 120°C par heure sous oxygène pur. Le produit obtenu, plus dense et mieux texturé que le produit de départ a conservé sa pureté grâce à la surveillance in situ de la résistivité qui a permis d'éviter la décomposition irréversible par fusion.

Bien entendu l'invention n'est pas limitée aux modes de réalisation qui viennent d'être décrits. On pourra, sans sortir du cadre de l'invention, remplacer tout moyen par un moyen équivalent.

## Revendications

1. Procédé de contrôle pour l'élaboration d'un matériau supraconducteur à haute température critique de formule
(BP)₂Sr₂CaₙCu₍₁₊ₙ₎O₍₆₊₂ₙ₎
avec
BP = Bi₍₁₋ₓ₎Pbₓ ;
n = 0 ; 1 ; 2,
procédé selon lequel :
- on part d'un mélange de poudres des précurseurs dudit matériau avec la stoechiométrie de la phase supraconductrice souhaitée,
- on agglomère ledit mélange pour former une pièce tubulaire ou cylindrique,
- on place la pièce agglomérée dans un four à atmosphère contrôlée pour réaliser la synthèse de ladite phase supraconductrice,
- on mesure de manière continue la conductivité de ladite pièce,
procédé caractérisé par le fait que :
- on dépasse la température pour laquelle la conductivité amorce une décroissance puis on revient à une valeur où la conductivité recommence à croître,
- on règle en permanence la température du four de manière à ce que ladite conductivité ne décroisse pas et se trouve à la limite d'un coude de décroissance.

2. Procédé selon la revendication 1, caractérisé par le fait que lesdits précurseurs sont choisis parmi :
SrCO₃
CaCO₃ ou CaO
Bi₂(CO₃)₃ ou Bi₂O₃
PbCO₃ ou PbO ou Pb₃O₄ .

3. Procédé selon l'une des revendications 1 et 2, caractérisé par le fait que l'on mesure ladite conductivité par la méthode dite "des quatre points" mettant en oeuvre quatre contacts.

4. Procédé selon la revendication 3, caractérisé par le fait que lesdits contacts sont en un matériau choisi parmi l'argent, le platine, le rhodium, l'or.

5. Procédé selon l'une des revendications 3 et 4, caractérisé par le fait que lesdits contacts sont réalisés sous forme de laque à la surface de ladite pièce, de fils noyés dans ladite pièce, de colliers ou de ressorts agissant par pression sur ladite pièce.

## Claims

1. A method of monitoring the fabrication of a superconductive material having a high critical temperature of formula
(BP)₂Sr₂CaₙCu₍₁₊ₙ₎O₍₆₊₂ₙ₎
where
BP = Bi₍₁₋ₓ₎Pbₓ;
n = 0; 1; 2
according to which method:
the starting material is a mixture of powders of precursors for said material having stoichiometric proportions appropriate for the desired superconductive phase;
the said mixture is agglomerated to form a tubular or a cylindrical piece;
the agglomerated piece is placed in a controlled-atmosphere oven for synthesizing said superconductive phase; and
the conductivity of said piece is measured continuously;
the method being characterized in that:
the temperature at which conductivity begins to decrease is exceeded and then the temperature is returned to a value where conductivity begins to increase; and
the temperature of the oven is permanently adjusted so that said conductivity does not decrease and lies at the limit of a decreasing turning point.

2. A method according to claim 1, characterized by the fact that said precursors are selected from:
SrCO₃
CaCO₃ or CaO
Bi₂(CO₃)₃ or Bi₂O₃ PbCO₃ or PbO or Pb₃O₄.

3. A method according to claim 1 or 2, characterized by the fact that said conductivity is measured by the "four point" method using four contacts.

4. A method according to claim 3, characterized by the fact that said contacts are made of a material selected from: silver, platinum, rhodium, and gold.

5. A method according to claim 3 or 4, characterized by the fact that said contacts are made in the form of varnish on the surface of said piece, wires embedded in said piece, or collars or springs pressing against said piece.

## Patentansprüche

1. Verfahren zur Kontrolle der Herstellung eines Supraleitermaterials mit hoher kritischer Temperatur gemäß der Formeln
(BP)₂Sr₂CaₙCu₍₁₊ₙ₎O₍₆₊₂ₙ₎
mit
BP = Bi₍₁₋ₓ₎Pbₓ
n = 0; 1; 2
wobei das Verfahren folgende Schritte aufweist:
- man nimmt eine Mischung von Pulvern von Präkursoren des Materials mit der Stöchiometrie der gewünschten supraleitenden Phase,
- man agglomeriert die Mischung und bildet ein rohrförmiges oder zylindrisches Bauteil,
- das agglomerierte Bauteil wird in einen Ofen mit kontrollierter Atmosphäre gebracht, wo die Synthese der supraleitenden Phase erfolgen soll,
- man mißt kontinuierlich die Leitfähigkeit des Bauteils,
dadurch gekennzeichnet, daß
- man die Temperatur überschreitet, bei der die Leitfähigkeit abzufallen beginnt und kehrt dann zu einem Wert zurück, bei dem die Leitfähigkeit wieder zu steigen beginnt,
- man regelt permanent die Temperatur des Ofens derart, daß die Leitfähigkeit nicht absinkt und an der Grenze eines Knicks nach unten bleibt.

2. Verfahren nach Anspruch 1, dadurch gekennzeichnet, daß die Präkursoren ausgewählt werden unter:
SrCO₃
CaCO₃ oder CaO
Bi₂(CO₃)₃ oder Bi₂O₃
PbCO₃ oder PbO oder Pb₃O₄.

3. Verfahren nach einem der Ansprüche 1 und 2, dadurch gekennzeichnet, daß die Leitfähigkeit mit der Vierpunktmethode gemessen wird, bei der vier Kontakte verwendet werden.

4. Verfahren nach Anspruch 3, dadurch gekennzeichnet, daß die Kontakte aus einem Material sind, das aus Silber, Platin, Rhodium und Gold ausgewählt wird.

5. Verfahren nach einem der Ansprüche 3 und 4, dadurch gekennzeichnet, daß die Kontakte als ein Lack auf der Oberfläche des Bauteils, als in das Bauteil eingebettete Drähte, als Schellen oder Federn ausgebildet sind, die durch Druck auf das Bauteil wirken.
